# EUROPEAN PATENT APPLICATION

(11) **EP 4 564 411 A1**
(43) Date of publication of application: **04.06.2025**
(21) Application number: 24205748.7
(22) Date of filing: 10.10.2024
(51) Int. Cl.: H01L 21/67, H01L 21/677

(54) **MODULAR EQUIPMENT MAINFRAME FOR SEMICONDUCTOR PROCESS FLOWS**

(30) Priority: 30.11.2023 US 202318524224
(71) Applicant: INTEL Corporation, Santa Clara, CA 95054 (US)
(72) Inventor: RUDOLPH, John William, Chandler, AZ 85226 (US); RADLOFF, Stefan Eric, Chandler, AZ 85248 (US); JUNG, Melvin Joseph, Gilbert, AZ 85296 (US); PETTINATO, Jeffrey Scott, Phoenix, AZ 85045 (US); MODI, Mitul Bharat, Phoenix, AZ 85044 (US); YOUNG, Jefferson Stephen, Queen Creek, AZ 85142 (US); NELSON, John Andrew, Chandler, AZ 85224 (US); WHEELER, Kirk Andrew, Chandler, AZ 85226 (US); MANEERATANA, Vasana, Tempe, AZ 85283 (US); DUNNING, Craig Scott, Chandler, AZ 85226 (US)
(74) Representative: HGF

(57) **Abstract**

Mainframes and systems for semiconductor device manufacturing are disclosed herein. In one embodiment, a mainframe includes one or more racks to removably couple process modules, where the process modules are to be arranged in rows, and one or more robots in a lane between the rows to transfer semiconductor workpieces to and from the process modules.

## Description

### BACKGROUND

Systems for packaging and assembling semiconductor devices typically use a series of linked tools to process semiconductor workpieces for a specific process flow by moving the workpieces between the process tools in a predefined STATIC order. These systems lack flexibility to add, remove, or insert process tools, or change the order in which workpieces are processed by the respective process tools. Further, any interruption or downtime of one of the process tools shuts down the processing for all of the process tools. This leads to inefficiencies in on-site support and overall availability of the process tools, which results in a loss of production capacity. Further, systems for fabricating semiconductor devices are typically based on proprietary designs with limited flexibility for different configurations, including the use process tools from different vendors and/or configurations that enable continuous processing to achieve maximum throughput for multiple process flows.

### BRIEF DESCRIPTION OF THE DRAWINGS

**FIGS. 1A-B** illustrate an example embodiment of an equipment mainframe for manufacturing semiconductor devices.
**FIGS. 2A-C** illustrate a front-end subsystem for an equipment mainframe.
**FIGS. 3A-C** illustrate a delivery subsystem for an equipment mainframe.
**FIGS. 4A-B** illustrate example utility connections on a process module.
**FIG. 5** illustrates a system with multiple equipment mainframes for manufacturing semiconductor devices.
**FIG. 6** illustrates an example process flow performed by a semiconductor manufacturing mainframe.
**FIG. 7** is a top view of a wafer and dies that may be included in a microelectronic assembly, in accordance with any of the embodiments disclosed herein.
**FIG. 8** is a cross-sectional side view of an integrated circuit device that may be included in a microelectronic assembly, in accordance with any of the embodiments disclosed herein.
**FIG. 9** is a cross-sectional side view of an integrated circuit device assembly that may include a microelectronic assembly, in accordance with any of the embodiments disclosed herein.
**FIG. 10** is a block diagram of an example electrical device that may include a microelectronic assembly, in accordance with any of the embodiments disclosed herein.

### DETAILED DESCRIPTION

Current systems for semiconductor device manufacturing suffer from various drawbacks. For example, systems for packaging and assembling semiconductor devices typically use a series of linked process tools, or process chambers, to process semiconductor workpieces for a specific process flow by moving the workpieces between the process chambers on conveyors in a predefined order (e.g., A to B, B to C, etc.). These systems lack flexibility to add, remove, or insert process chambers, or change the order in which workpieces are processed by the respective process chambers. Further, any interruption or downtime of one of the process chambers shuts down the processing for all of the process chambers. This leads to inefficiencies in on-site support and overall availability of the process tools, which results in a loss of production capacity. Further, systems for fabricating semiconductor devices are typically based on proprietary designs with limited flexibility for different configurations, including the use process tools from different vendors and/or configurations that enable continuous processing to achieve maximum throughput for multiple process flows.

Accordingly, this disclosure presents embodiments of an equipment mainframe with integrated material handling and process modules for semiconductor process flows, including, without limitation, substrate panel processing, substrate quarter panel processing, wafer processing, advanced packaging, and single unit packaging. The described embodiments define a new system of material handling and management of process tool modules to reduce manpower requirements and enable autonomous operation.

In some embodiments, for example, the mainframe may include the following components or subsystems: (i) an equipment front-end module (EFEM) to receive transport carriers containing trays of semiconductor workpieces (e.g., from the factory automated material handling system (AMHS)); (ii) a modular rack system to support flexible configurations of process modules; (iii) a robotic system to move trays of semiconductor workpieces to and from the various process modules contained in the racks; and (iv) a utility distribution module to manage the connection of required utilities to process modules and enable easy connection and disconnection of utilities when process modules are added or removed during operation.

The described embodiments provide various advantages. In particular, the definition and design of the system allows for added flexibility and higher efficiency in operation and movement of material. For example, the workpiece, or work in progress (WIP), is delivered to the system automatically and then distributed to the process modules in any order based on the process steps required. All movement of material is performed automatically, which significantly reduces the required manpower. Further, the maintenance of the system is simplified, as individual modules can be inserted or removed while the remaining modules are in operation, which significantly reduces the impact of downtimes with respect to the output of linked process modules. The system also defines standardized sizing and docking features for process modules (e.g., mounting features, utility connections) to drive a common modular framework for inserting and removing process modules on the rack. Other advantages will be readily apparent from the description provided throughout this disclosure.

Throughout this disclosure, a "unit" may refer to a single semiconductor product (e.g., die, chip, package). A "strip" may refer to a group of units on a single substrate (e.g., a panel or wafer with unsingulated dies or packages). A "workpiece" or "work in progress" (WIP) may refer to a unit, strip, or other semiconductor product/material in the process of being worked on (e.g., processed, manufactured, transported, etc., whether unfinished or finished). A "tray" may refer to a medium or container used to hold one or more semiconductor workpieces. A "transport carrier" may refer to a container or cassette used to hold and transport semiconductor workpieces (either within trays or without using trays) (e.g., a front opening unified pod (FOUP) with an automated door).

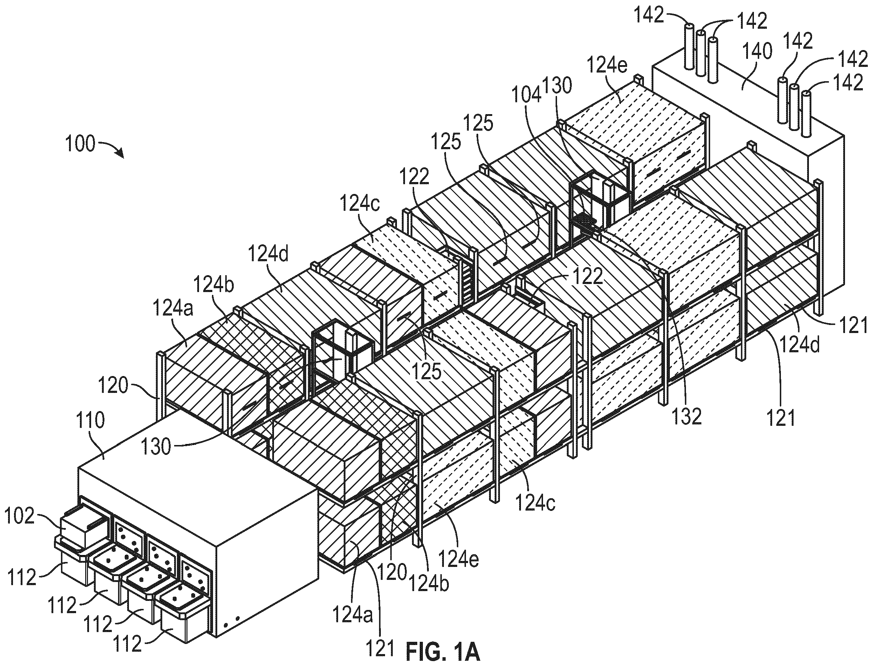

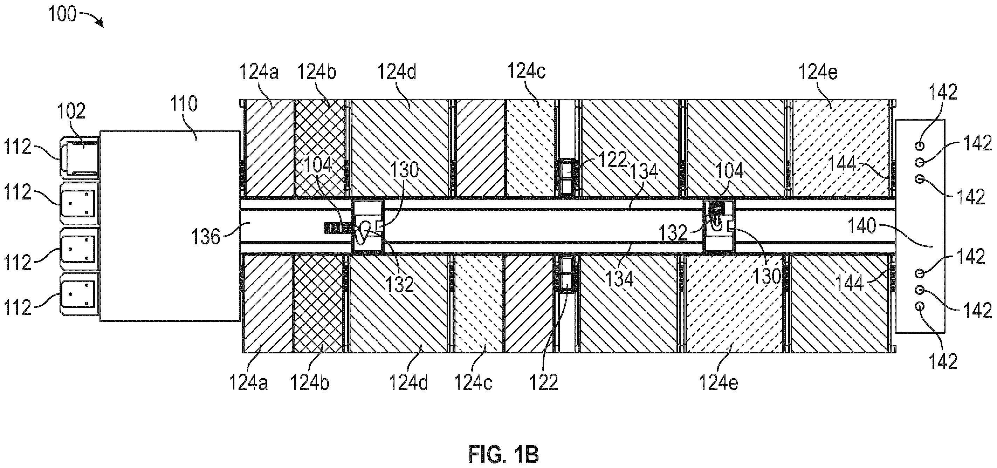

**FIGS.** 1A-B illustrate an equipment mainframe system 100 for manufacturing semiconductor devices in accordance with certain embodiments. In particular, FIGS. 1A and 1B illustrate perspective and plan views of the equipment mainframe system 100, respectively. In the illustrated embodiment, mainframe 100 is a material handling and distribution system for semiconductor manufacturing that supplies semiconductor workpieces to process modules 124 installed on racks 120. Mainframe 100 is designed based on a set of standards that define how a set of process operations are managed around the system to efficiently deliver materials to the various process modules 124. The benefits include reduced labor requirements and decreased impact from downtimes of process modules 124, which results in lower costs and higher production output. Accordingly, mainframe 100 may be deployed in a factory to manufacture semiconductor devices with greater automation, flexibility, and efficiency than existing systems.

In the illustrated embodiment, mainframe 100 includes a front-end subsystem 110, process module racks 120, delivery robots 130, and a utility distribution subsystem 140.

The front-end subsystem 110, which may also be referred to as an equipment front-end module (EFEM) 110, includes multiple load ports 112 to interface with the factory material handling system (e.g., a factory automated material handling system (AMHS) and/or person-guided vehicles (PGVs) for delivery and pickup of transport carriers 102 containing trays 104 of semiconductor workpieces. For example, the factory material handling system (e.g., factory AMHS and/or PGVs) delivers transport carriers 102 to the load ports 112 on the front-end subsystem 110. The trays 104 of semiconductor workpieces are unloaded from the transport carriers 102 via the load ports 112, processed through the mainframe 100 (e.g., as described further below), and then loaded back into the transport carriers 102 via the load ports 112 once processing is complete. The factory material handling system (e.g., factory AMHS and/or PGVs) then picks up the transport carriers 102 from the load ports 112 and transfers them to the next destination, such as another mainframe for additional processing, a storage facility (e.g., AMHS stockers), etc.

The process modules racks 120 are structures that enable process modules 124a-e to be docked in modular configurations. In the illustrated embodiment, the racks 120 support four rows of process modules 124, with two rows stacked vertically on each side of a center transport lane 136.

The delivery robots 130 reside in the center transport lane 136 (e.g., the aisle between the rows of process modules 124a-e on the racks 120) and are used to transfer trays 104 of semiconductor workpieces between the front-end subsystem 110 and the respective process modules 124 (using tray buffer racks 122 in the middle for tray handoffs between the delivery robots 130).

The utility distribution subsystem 140 provides common connections 142 to factory utilities-such as power, air, water, chemicals/gas, vacuum, exhaust, and network connectivity-along with routing 144 to distribute the utilities to the respective subsystems and components of mainframe system 100, including the process modules 124 (e.g., with standardized connectors to easily connect and disconnect utilities when adding or removing process modules during operation), the front-end subsystem 110, the mainframe control system, etc. In the illustrated embodiment, for example, the utility distribution subsystem 140 includes a housing with dedicated connections 142 to factory utilities and routing 144 to distribute the utilities to process modules 124 at each slot 121 on the process module racks 120.

The mainframe 100 may also include a control system (not shown) (e.g., processing circuitry such as a processor or controller and optionally other computing components) to control the respective components of mainframe 100 (e.g., front-end subsystem 110, delivery robots 130, etc.), communicate with the host system (e.g., factory control system, AMHS) and the respective process modules 124, and so forth.

In the illustrated embodiment, for example, transport carriers 102 containing trays 104 of semiconductor workpieces are delivered to load ports 112 on the front-end subsystem 110 by the factory material handling system (e.g., the factory AMHS and/or PGVs) (not shown). Each transport carrier 102 may contain one or more trays 104 (or one or more stacks of trays 104), and each tray 104 may contain one or more semiconductor workpieces. The trays 104 are automatically unloaded from the transport carriers 102 via the load ports 112 and then buffered within the front-end subsystem housing 110.

The delivery robots 130 then transfer individual trays 104 (e.g., one by one) from the front-end subsystem 110 to the respective process modules 124 in the order required by a particular process flow(s) for manufacturing semiconductor devices. Each process module 124 performs certain operations on the semiconductor workpieces in one or more trays 104 transferred to the process module 124, and once complete, the current tray(s) 104 may be transferred out and delivered to the next process module(s) 124, and new tray(s) 104 may be transferred in by the delivery robots 130 (or otherwise retrieved from a tray buffer area of the process module 124 if those tray(s) 104 were already transferred in by the delivery robots 130). In this manner, the process modules 124 are continuously processing semiconductor workpieces without any idle time.

Once processing is complete, the delivery robots 130 return the trays 104 to the front-end subsystem 110, and the front-end subsystem 110 automatically loads the trays 104 back into the appropriate transport carriers 102. In this manner, lot boundaries can be maintained when needed, as trays 104 can be returned to same transport carrier 102 they were delivered in. The transport carriers 102 are then picked up via the load ports 112 (e.g., by the factory AMHS and/or PGVs) and transferred to the next destination in the factory, such as another mainframe (e.g., to continue processing the workpieces) or a storage facility (e.g., to store the completed workpieces).

The process modules 124, which may also be referred to as "cells," are modular pieces of equipment capable of being docked on the racks 120 and designed to perform discrete functions relating to semiconductor manufacturing (e.g., value added processing on semiconductor workpieces).

In particular, each process module 124 may be designed to perform a particular function or operation on, or associated with, semiconductor workpieces, such as a process, metrology, or material handling function. Examples of the functions that may be performed by process modules 124 include, without limitation, film deposition, etch, annealing, ion implantation, cleaning, curing, bonding, assembly, singulation, buffering, handling, and metrology measurement.

A process module 124 may include a process chamber to perform its designated function (e.g., an enclosed space with the requisite tools to perform the function), along with one or more interfaces 125 to transfer semiconductor workpieces in and out of the process chamber (e.g., an opening or slot, optionally with an automated door, to transfer individual trays of semiconductor workpieces, or individual workpieces such as a strip or unit, in and out of the process chamber). Further, in some embodiments, a process module 124 may also include mechanisms (e.g., racks/shelves) to temporarily buffer or store trays 104 that have been transferred in (e.g., until they are ready to be processed) and/or trays 104 that are ready to be transferred out (e.g., after they have been processed and are waiting to be picked up by a delivery robot 130).

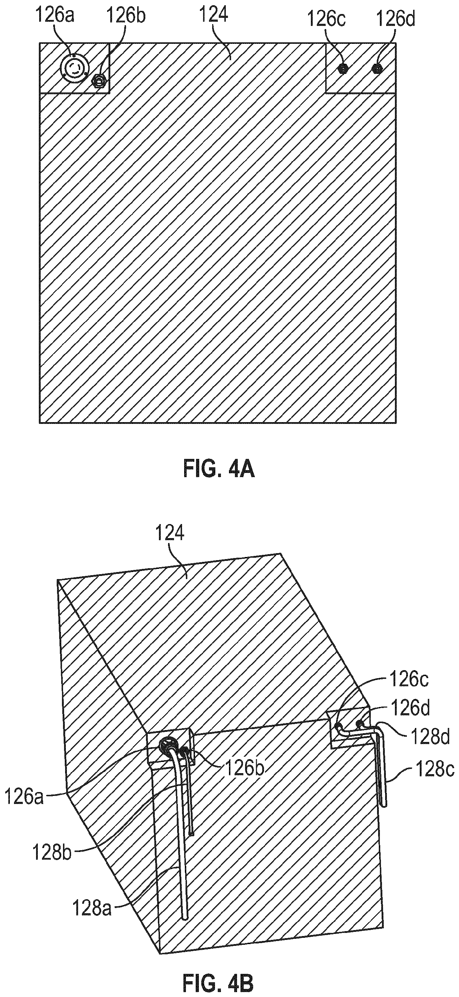

Further, a process module 124 may include standard connectors for common utilities (e.g., as described further with respect to FIGS. 4A-B), along with mechanisms to enable the process module 124 to be docked on the rack 120.

A process module 124 may also include a control system (e.g., processing circuitry such as a processor or controller and optionally other computing components) to control the operation of the process module 124 (e.g., the operations performed in the process chamber), communicate with the host system and/or the mainframe 100, and so forth.

The respective process modules 124 may vary in both type (e.g., type of function/operation performed) and size (e.g., dimensions). In the illustrated embodiment, there are five types of process modules 124a-e of varying types and sizes docked on the rack 120. In particular, each type of process module 124a-e may perform a different function, and some of them 124a-c are standard width while others 124d-e are double width.

Each process module 124 is typically designed to operate independently and in parallel with all other process modules 124 in the mainframe 100. Further, the process modules 124 can be "linked" to collectively perform some or all of a particular semiconductor manufacturing process flow (e.g., by transferring semiconductor workpieces between the process modules 124 in a particular order using the delivery robots 130). Examples of the process flows that may be implemented by linked process modules 124 include, without limitation, singulated package assembly, strip package assembly, wafer-level assembly, quarter-panel substrate fabrication, and full-panel substrate fabrication.

The process module rack system 120 is a sectional structure composed of one or more individual racks 120 that enable process modules 124a-e to be docked in modular configurations (e.g., multiple rows of process modules arranged horizontally and/or vertically). In the illustrated embodiment, the rack system 120 includes two separate rack structures 120 on opposite sides of a center transport lane 136, where each rack structure 120 supports two rows of process modules 124 stacked vertically, for a combined total of four rows. For example, each rack structure 120 includes multiple levels (e.g., shelves or platforms arranged vertically), and each level is used to dock a row of process modules 124.

In some embodiments, the racks 120 may include individual slots 121 for docking process modules 124. For example, each slot 121 may be a position on a rack 120 with features for docking a process module 124, and each process module 124 may have complementary features to interface with those on a rack slot 121. In some embodiments, the respective docking features on the rack slots 121 and process modules 124 may include, without limitation, mechanical features to align, mate, and/or fasten a process module 124 to a rack slot 121 (e.g., grooves, holes, pins, tracks, rails, fasteners, etc.), utility connections 144 to connect a process module 124 to factory utilities (e.g., via the utility distribution subsystem 140 and factory utility connections 142), etc.

Further, in some embodiments, certain aspects of the racks 120 and/or process modules 124 may be standardized, such as the size of rack slots 121 and process modules 124, mechanical features available for mounting process modules 124 to rack slots 121, utility connections available on or at process modules 124 and rack slots 121, etc.

In some embodiments, for example, the slots 121 on the rack 120 may support multiple sizes of process modules 124 with standardized dimensions. As an example, the rack slots 121 may support process modules with widths of 1W, 2W, or 3W, heights of 1H or 2H, and a depth of ID, where W, H, and D represent the standard base width, height, and depth, respectively. In this scheme, the following sizes of process modules are supported: standard (WxHxD), double wide (2WxHxD), triple wide (3WxHxD), double high (Wx2HxD), double wide/double high (2Wx2HxD), and triple wide/double high (3Wx2HxD). For example, a "standard" process module has standard width (W), height (H), and depth (D), a "double wide" process module is two times wider than the standard width (W), a "triple wide" process module is three times wider than the standard width (W), a "double high" process module is two times taller than the standard height (H), etc. Further, the number of rack slots 121 occupied by a process module 124 may vary based on its size. For example, a "standard" process module may occupy one slot, a "double wide" process module may occupy two slots, and a "triple wide" process module may occupy three slots.

Further, each process module 124 and rack slot 121 may have standard connections for utilities, including, without limitation, electrical connections (e.g., power), mechanical connections (e.g., air, water, chemicals/gas, exhaust, vacuum), network connections (e.g., for network connectivity/communication), etc. These utility connections may be routed from process module 124 to rack slot 121, rack slot 121 to utility subsystem 140, and utility subsystem 140 to factory utilities.

In this manner, mainframe 100 is designed to support "hot swappable" process modules 124 that can be added to or removed from the rack 120 quickly and safely without interrupting the operation of mainframe 100. For example, while mainframe 100 is operating, individual process modules 124 can be mounted/unmounted to/from the rack 120 and connected/disconnected to/from utilities. As a result, individual process modules 124 can be seamlessly added, removed, and/or replaced (e.g., for maintenance/repair or to rebalance the processing line to increase utilization) while the remaining process modules 124 and the mainframe 100 continue operating.

Maintenance and repairs can be performed on process modules 124 with or without removing them from the mainframe 100. For example, for minor maintenance and repairs (e.g., simple recovery, short scheduled maintenance), a process module 124 may be serviced while remaining in the mainframe 100. For major maintenance and repairs (e.g., periodic scheduled maintenance, deep cleaning, part failure/return to production), a process module 124 may be removed from the mainframe 100 and serviced offline (e.g., in a work area or repair facility).

In the illustrated embodiment, the mainframe system 100 is designed for tray-based processing, where trays 104 are used to transport semiconductor workpieces such as die, stacked die, singulated substrates, a strip of substrates, quarter panel substrates, full panel substrates, packaged memory, and other required materials to fabricate, assemble, measure, and test a semiconductor device, such as a die, package, die stack, substrate panel, etc. Further, multiple sizes of trays are supported to accommodate semiconductor workpieces (e.g., dies and packages) of varying sizes (e.g., larger trays to accommodate larger workpieces, smaller trays for smaller workpieces).

Further, the mainframe system 100 supports full tray and unit-level traceability/tracking for any and all components using unique visual and/or electronic identifiers (IDs) (e.g., two-dimensional (2D) matrix marks, RFID tags, etc.), thus ensuring that trays 104 are returned to the same transport carriers 102 they were removed from (when required). For example, tray IDs may be read by sensors at various points throughout the operation of mainframe 100, including, without limitation, when trays 104 are unloaded from transport carriers 102 and/or reloaded back into the transport carriers 102, when trays 104 are dispatched from the front-end subsystem 110 and/or returned to the front-end subsystem 110, when trays 104 are delivered to process modules 124 and/or retrieved from process modules 124, etc.

In other embodiments, however, the mainframe system 100 may be designed to transport and process semiconductor workpieces without using trays 104 (e.g., by handling the semiconductor workpieces directly or transporting them in other mediums or containers).

Mainframe system 100 provides various advantages. For example, labor associated with process modules or cells is significantly reduced (e.g., up to 90%) due to autonomous operation and automated material movement, ability to replenish tools automatically, ability to perform maintenance on process modules with or without removing them and while the mainframe continues operating, etc.

The mainframe system supports fully automated material handling of both direct materials (e.g., materials consumed during manufacturing such as a die attached to a package substrate and epoxy used to attach the die) and indirect materials (e.g., materials used but not consumed during manufacturing such as jigs, fixtures, and other support structures for dies, chips, and packages), including material replenishment and collateral management.

The mainframe system provides increased availability and utilization by eliminating or drastically reducing process module maintenance, as the mainframe system is designed to dramatically reduce repair labor and time and move from periodic maintenance to predictive (e.g., signal based) maintenance. For example, the mainframe system supports fully automated quick swap of process module parts and swap-on-error standby systems (e.g., spare dispense heads and other parts can be automatically reloaded by tools). Process modules can be swapped in and out to perform routine maintenance and repairs on process modules offsite or offline (e.g., by a field service engineer (FSE)) while the mainframe system continues operating. Responsive maintenance is reduced using cost-effective automated maintenance to address common needs and issues. Finally, predictive Internet-of-Things (IoT) maintenance is leveraged to avoid failures and reduce the required manpower to respond quickly.

The mainframe system also reduces the required labor for many other operational aspects, including lot movement and location (e.g., automated transfer of transport carriers by the factory AHMS, automated dispatch systems to identify what to process and when), link operation (e.g., support for a remote operation center and autonomous tools based on factory planning, scheduling, and execution systems, elimination of pre-lot operator checks), and so forth.

Further, the mainframe system is highly modular and scalable and supports numerous variations, including the number, type, and arrangement of process modules, the number and arrangement of process module rows (e.g., total number of rows, number of vertically stacked rows, number of rows per side, number of process modules per row), the number and arrangement of rack slots for docking process modules, the utility connections available to or available on the process modules, the number and type of robots for automated material handling, the dimensions of transport carriers, trays, and process modules, and so forth.

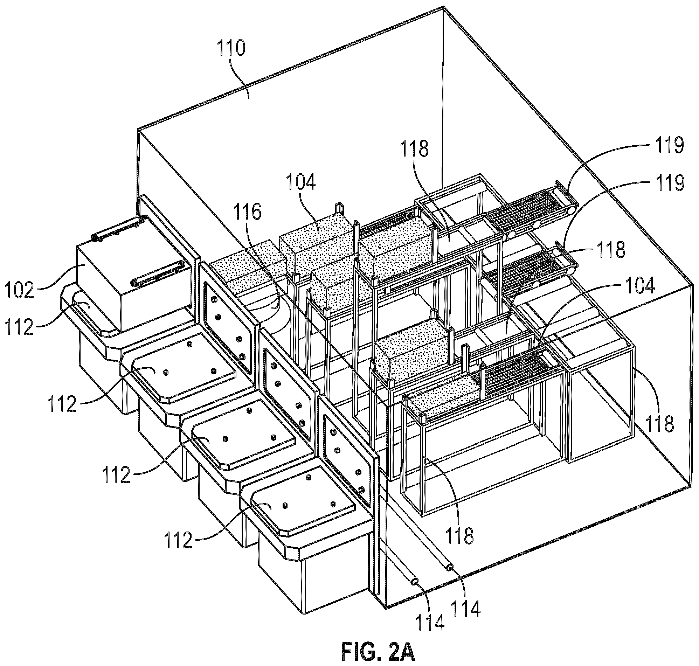

Example embodiments of the front-end subsystem 110, the delivery robots 130, and the utility connections on a process module 124 are shown and described in further detail in FIGS. 2A-C, FIGS. 3A-C, and FIGS. 4A-B, respectively.

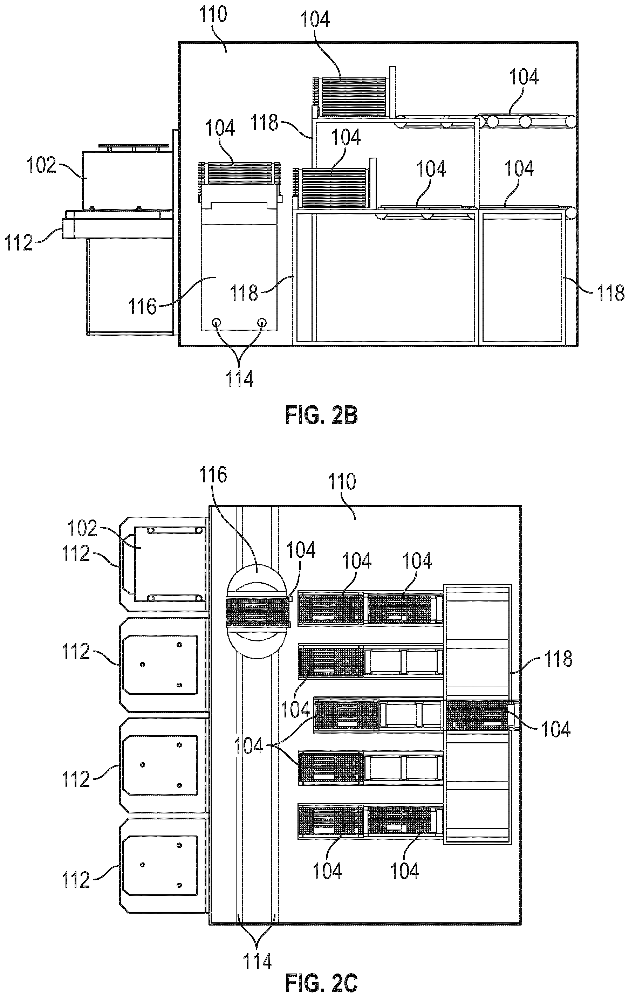

**FIGS. 2A-C** illustrate the front-end subsystem 110 of the mainframe 100 (also referred to as the equipment front-end module (EFEM)). In particular, FIGS. 2A, 2B, and 2C illustrate perspective, side, and plan views of the front-end subsystem 110, respectively. As described further below, the front-end subsystem 110 is a feeder system that feeds trays 104 of semiconductor workpieces to the mainframe 100 for processing by the respective process modules 124.

In the illustrated embodiment, the front-end subsystem 110 includes multiple external load ports 112 (e.g., four load ports) to receive transport carriers 102 containing trays 104 of semiconductor workpieces, along with housing that contains an internal front-end material handling subsystem to unload the trays 104 from the transport carriers 102 and buffer or queue the trays 104 until the mainframe 100 is ready to process them (and subsequently reload the trays 104 back into the transport carriers 102 after processing). In this manner, the front-end subsystem 110 supports buffering of multiple transport carriers 102, along with lot- or batch-level buffering of trays 104 within the same transport carrier 102, to enable the mainframe 100 to continuously process trays 104 of semiconductor workpieces. Further, trays 104 from the respective transport carriers 102 can be fed into or removed from the mainframe 100 for multiple manufacturing segments or capabilities, including, without limitation, singulated package assembly, strip package assembly, wafer-level assembly, quarter-panel substrate fabrication, and full-panel substrate fabrication.

In the illustrated embodiment, each load port 112 includes an interface designed to receive a transport carrier 102 from the factory material handling system or operator (e.g., a factory automated material handling system (AMHS) or person-guided vehicle (PGV)), along with mechanisms to dock the transport carrier 102 (e.g., securely hold the transport carrier 102 in place on the docking interface of the load port 112) and open and close the door on the transport carrier 102 (e.g., to unload and/or reload its contents). In some embodiments, for example, the door on the transport carrier 102 may be opened by physically removing the door from the carrier 102 and lowering it out of the way (e.g., into a compartment within the front-end subsystem 110), and the door on the transport carrier 102 may be closed by raising the door back up and reattaching it to the transport carrier 102.

The front-end material handling subsystem is housed in the front-end subsystem 110 and includes a robot 116, tracks 114 along the floor (e.g., rails) for robot movement, a tray buffer subsystem 118, and multiple tray in/out (I/O) interfaces 119 (e.g., openings 119 to feed trays 104 in and out of the front-end subsystem 110 to and from the delivery subsystem 130).

The robot 116 is configured to move along the tracks 114 to unload trays 104 from the transport carriers 102 via the load ports 112 and move them to the tray buffer subsystem 118, and vice versa (e.g., reload trays 104 from the tray buffers 118 back into the transport carriers 102).

The tray buffer subsystem 118 includes one or more racks and/or conveyors to temporarily hold or store trays 104 until they are ready to be processed by the mainframe 100, or alternatively, until they are ready to be reloaded back into the transport carriers 102 by the robot 116 after processing.

In some embodiments, for example, when the factory material handling system or operator (e.g., factory AMHS and/or PGV) delivers a transport carrier 102 to one of the load ports 112, the docking mechanisms on the load port 112 are activated to secure the transport carrier 102 to the docking surface, and the load port 112 may open and/or remove the door on the transport carrier 102 to provide access to the trays 104 inside the carrier 102 (and optionally lower the door into the front-end subsystem 110 to get it out of the way).

The internal robot 116 moves along the tracks 114 to the internal interface of the load port 112 (e.g., within the housing of the front-end subsystem 110), and then unloads the trays 104 from the transport carrier 102 onto the tray buffer racks 118 (e.g., by lifting the trays 104 up from the carrier 102 and placing them back down on the racks 118).

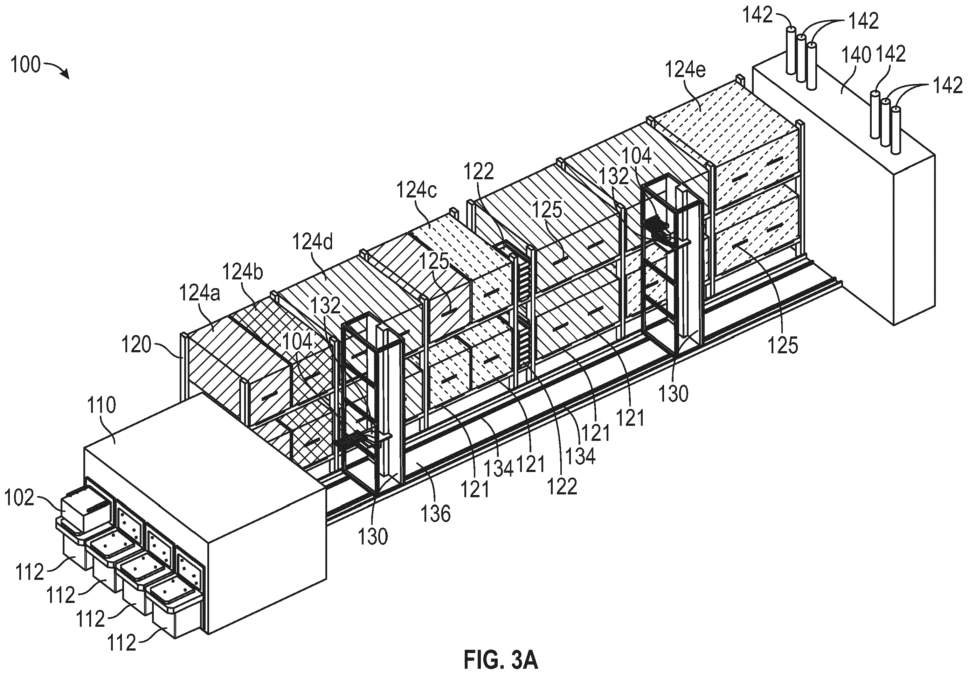

The tray buffer subsystem 118 includes a rack to buffer the trays 104 along with mechanisms to unstack the trays 104 (if necessary) and transfer them out of the front-end subsystem 110 when the mainframe 100 is ready to process them. For example, when a tray 104 is ready to be processed by the mainframe 100, the tray buffer subsystem 118 outputs the tray 104 on a conveyor through one of the tray in/out interfaces 119 to the delivery subsystem 130 (e.g., one of the delivery robots 130). The delivery subsystem 130 then transfers the tray 104 to and from the appropriate process modules 124, in the appropriate order, as described further throughout this disclosure (e.g., with respect to FIGS. 1A-B and FIGS. 3A-C).

Once processing is complete, the delivery subsystem 130 transfers the tray 104 back to the front-end subsystem 110 (e.g., via one of the tray in/out interfaces 119), where the tray 104 is once again buffered on the tray buffer subsystem 118 until it is ready to be reloaded into its original transport carrier 102. For example, the tray 104 may be buffered in the front-end subsystem 110 until all other trays 104 from the same transport carrier 102 have been processed and transferred back to the front-end subsystem 110.

As trays 104 are returned to the front-end subsystem 110, trays 104 from the same transport carrier 102 may be restacked (as necessary) by the stack/unstack mechanisms in the tray buffer subsystem 118. The robot 116 reloads the trays 104 into the transport carrier 102 via the load port 112 (e.g., by lifting the trays 104 up from the tray rack 118 and placing them back down inside the carrier 102), and the door on the transport carrier 102 is then closed or replaced (e.g., by raising the door back up from the front-end subsystem 110 and reattaching it to the transport carrier 102).

The load port 112 then deactivates its docking mechanisms to release the transport carrier 102, and the factory material handling system or operator (e.g., factory AMHS or PGV) retrieves the carrier 102 from the load port 112 and transfers it to the next destination (e.g., another mainframe, a storage facility, etc.).

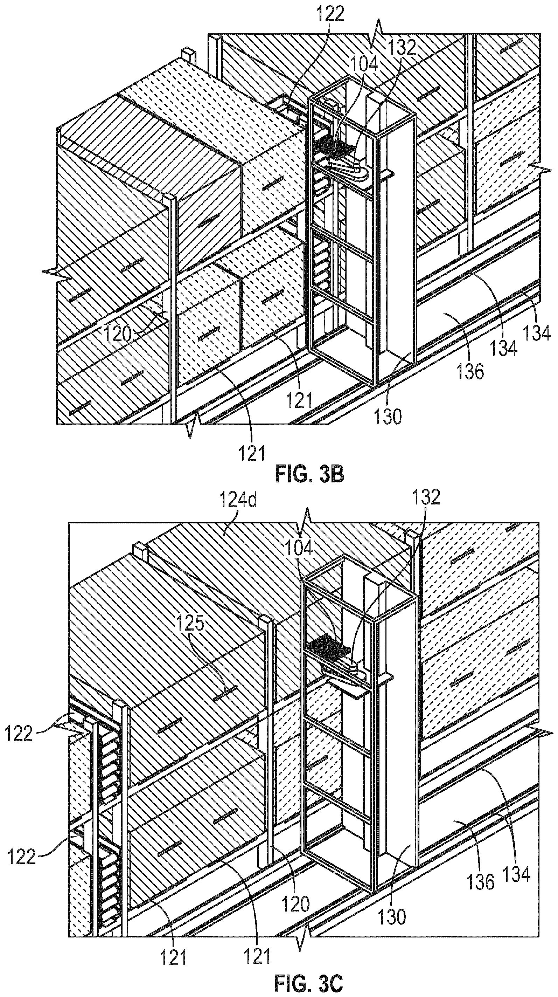

**FIGS. 3A-C** illustrate the delivery subsystem of mainframe 100, which includes multiple delivery robots 130 that move along tracks 134 in a center transport lane 136 to deliver trays 104 to and from the process modules 124. In particular, FIG. 3A illustrates a perspective view of the mainframe 100 with one side of the rack 120 and process modules 124 hidden to show the delivery robots 130 in the center transport lane 136. FIG. 3B illustrates a zoomed-in view of one of the delivery robots 130 loading a tray 104 onto, or unloading the tray 104 from, one of the tray handoff racks 122. FIG. 3C illustrates a zoomed-in view of one of the delivery robots 130 feeding a tray 104 into, or removing the tray 104 from, one of the process modules 124 (e.g., via the tray in/out interface 125 on the process module 124).

In the illustrated embodiment, the delivery subsystem includes multiple delivery robots 130 in a center transport lane 136 (e.g., between the rows of process modules 124). The robots 130 move along tracks 134 (e.g., rails) on the floor of the center transport lane 136 to deliver trays 104 to and from the process modules 124 (e.g., via the tray in/out interfaces 125), thus enabling the process modules 124 to perform the requisite processing on the semiconductor workpieces in the trays 104.

For example, in the illustrated embodiment, there are two delivery robots 130 in the center transport lane 136, and each robot 130 services a different half of the lane 136, or "zone," delivering trays 104 to and from process modules 124 in that zone.

Further, the delivery robots 130 use a shared tray buffer 122 in the middle of the two zones to transfer trays 104 between zones using buffered tray handoffs. For example, the tray buffer 122 includes multiple tray racks or shelves on each side of the center transport lane 136 in the middle of the two zones. If a tray 104 needs to be transferred between zones, one of the robots 130 transfers the tray 104 from its current location in the first zone (e.g., the front-end subsystem 110 or one of the process modules 124 in that zone) to a tray handoff rack 122, and the other delivery robot 130 transfers the tray 104 from the tray handoff rack 122 to the appropriate destination in the second zone (e.g., the front-end subsystem 110 or one of the process modules 124 in that zone). An example of a tray handoff using the tray handoff rack 122 is depicted in FIGS. 3B-C.

In the illustrated embodiment, the delivery robots 130 are attached to tracks 134 that extend along the center transport lane 136 and enable the robots 130 move within their respective zones of the transport lane 136. Further, each delivery robot 130 includes a robotic arm 132 with an end effector (e.g., with one or more ends) to handle trays 104, and the robotic arm 132 is attached to an elevator that moves up and down a vertical shaft. In this manner, the delivery robots 130 are capable of moving in multiple directions along X, Y, and Z axes: along the center transport lane 136 on the tracks 134 (X axis); vertically on the elevator shaft (Y axis); and in various directions using the robotic arm 132 (e.g., moving the arm 132 towards the process modules 124 (Z axis) or towards the front-end subsystem 110 (X axis) to pick up and/or deliver trays 104).

In some embodiments, the mainframe control system handles dispatching of trays 104 to and from the respective process modules 124 based on the applicable semiconductor process flows and process module availability. When a tray 104 is dispatched by the mainframe control system, the delivery robots 130 transfer the tray 104 to and from the appropriate process modules 124, in the appropriate order, as required by the particular semiconductor process flow for that tray 104.

For example, when the tray 104 is first dispatched, the delivery robot 130 in the zone adjacent to the front-end subsystem 110 retrieves the tray 104 from the front-end subsystem 110 and delivers it to the first destination, such as directly to one of the process modules 124 in that zone, or indirectly to one of the process modules 124 in the other zone via tray handoff to the other robot 130 using the tray handoff buffer 122.

As each process module 124 finishes processing the tray 104, the robot 130 servicing the zone of that process module 124 retrieves the tray 104 from the process module 124 and delivers it to the next process module 124 required by the particular semiconductor process flow (e.g., directly or indirectly via the tray buffers 122). The robots 130 continue transferring the tray 104 between process modules 124 in this manner until the tray 104 has been processed by all process modules 124 required by the particular semiconductor process flow.

Once processing is complete, one or both of the delivery robots 130 transfer the tray 104 back to the front-end subsystem 110, where the tray 104 may be loaded back into its original transport carrier 102, as described further throughout this disclosure (e.g., with respect to FIGS. 1A-B and FIGS. 2A-C).

In some embodiments, each process module 124 may have one or more interfaces 125 at predefined locations for transferring trays 104 in and out of the process module 124 (e.g., for tray delivery and pickup), which may be configured as input, output, or bi-directional. The number, location, and configuration of these tray interfaces 125 may be defined by each process module 124 based on its needs.

When a tray 104 is delivered to a process module 124, the process module 124 may move or manipulate the tray 104 and/or the semiconductor workpieces within the tray 104 as needed and may perform any required operations or actions on the semiconductor workpieces (e.g., process, metrology, cure, buffering, handling operations).

The process module 124 may also track the respective trays 104 (e.g., based on tray identifiers or IDs) and the semiconductor workpieces within the trays 104 throughout the processing performed by the process module 124 (e.g., ensuring that semiconductor workpieces are returned to the tray 104 they are delivered in, when required).

Moreover, the operation of the mainframe 100 is not impeded by the processing performed by a given process module 124; rather, the mainframe 100 continues transferring trays 104 to and from process modules 124.

Finally, in other embodiments, other suitable types of delivery subsystems may be used instead of, or in addition to, the delivery robots 130 shown in the illustrated embodiment (e.g., overhead conveyors, ground conveyors, ground-based robots, etc.).

**FIGS. 4A-B** illustrate an example of the utility connections on a process module 124. In particular, FIG. 4A shows the connectors/interfaces 126a-d for utilities on the backside of the process module 124, and FIG. 4B shows the corresponding utility connections 128a-d connected to those connectors/interfaces 126a-d.

In FIG. 4A, the following utility connectors/interfaces 126a-d are shown on the process module 124: a power socket 126a to supply power; a network interface 126b to provide network connectivity (e.g., for communication with other process modules 126, the mainframe 100, and/or the host system via their respective hardware/software controllers or control systems); and water supply and return line connectors 126c-d for water supply and return.

In FIG. 4B, the following utility connections 128a-d are connected to the connectors/interfaces 126a-d on the process module 124: a power cable 128a (connected to the power socket 126a); a network cable 128b (connected to the network interface 126b); and water supply and return lines 128c-d (connected to the water supply and return connectors 126c-d).

It should be appreciated that the utility connectors 126a-d and connections 128a-d shown on process module 124 are merely examples, and other types of utility connectors/connections may be included in actual embodiments.

In general, the mainframe 100 and the process modules 124 may have standard connectors/connections for common utilities, including, without limitation: power (e.g., 480, 208, or 120 volt (V) alternating current (AC)); air (e.g., oil-free air (OFA) / oxygen (O) at a particular pressure and flow rate); water (e.g., process chilled water (H₂O) at a particular flow rate and/or temperature, such as for cooling); chemicals/gases; general exhaust (e.g., at a particular flow rate); vacuum; and network connectivity (e.g., Ethernet port/cable).

Moreover, the connector types and sizes (e.g., sockets, plugs, interfaces, mechanical connectors) for common utilities may be standardized to ensure compatibility between the mainframe 100 and the wide variety of heterogenous process modules 124 that may potentially be docked on the mainframe 100 (which may come from different vendors).

Further, the respective utilities may be routed through dedicated connections to the mainframe 100 and then distributed to each slot/position 121 on the process module rack 120 (such that the process modules 124 share common utility connections instead of having separate connections per module 124), thus enabling quick connection and disconnection of utilities when adding and/or removing process modules 124 (e.g., without interrupting the operation of the mainframe 100). For example, common utilities may be routed from the factory to the utility distribution subsystem 140, from the utility distribution subsystem 140 to the rack slots 121, and from the rack slots 121 to the process modules 124.

Further, some process modules 124 may have custom requirements for non-standard utilities, which may be incorporated on an as-needed basis (e.g., on the respective process modules 124 and the mainframe 100). For example, certain process modules 124 may include connectors for non-standard utilities, and the mainframe 100 may have dedicated or pre-allocated space for adding routing/connections 142, 144 to those additional utilities (e.g., underneath the process module racks 120 and/or within the utility distribution subsystem 140).

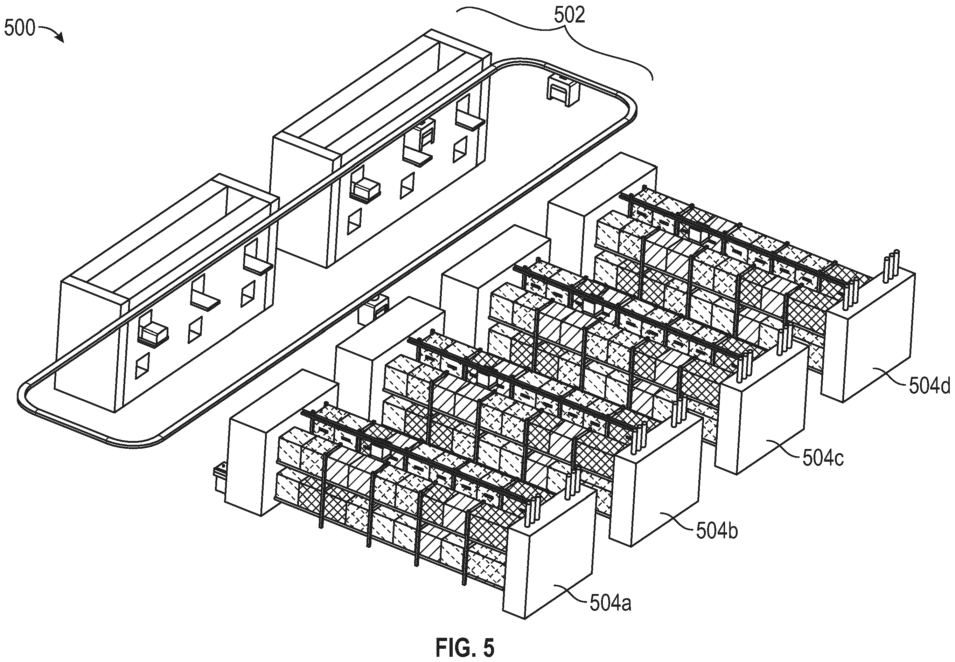

**FIG. 5** illustrates an example embodiment of a system 500 with an automated material handling system (AMHS) 502 and multiple mainframes 504a-d for semiconductor manufacturing. In some embodiments, the system 500 may be deployed in a semiconductor manufacturing factory. In the illustrated embodiment, the AMHS 502 includes stockers (e.g., storage compartments) to store or buffer transport carriers containing trays of semiconductor workpieces, along with mechanisms to transport and deliver the transport carriers to and from the mainframes 504a-d (e.g., via a ceiling-based conveyor system). Each mainframe 504a-d unloads trays from the carriers and feeds each tray to some or all of its process modules in the order required by a particular process flow to perform the requisite processing on the workpieces within the tray. In some embodiments, each mainframe 504a-d may be similar to mainframe 100. Further, in some embodiments, the system 500 may include a host control system (e.g., processors/controllers) to coordinate the flow between the AMHS 502, the respective mainframes 504a-d, and/or the process modules docked on the mainframes 504a-d.

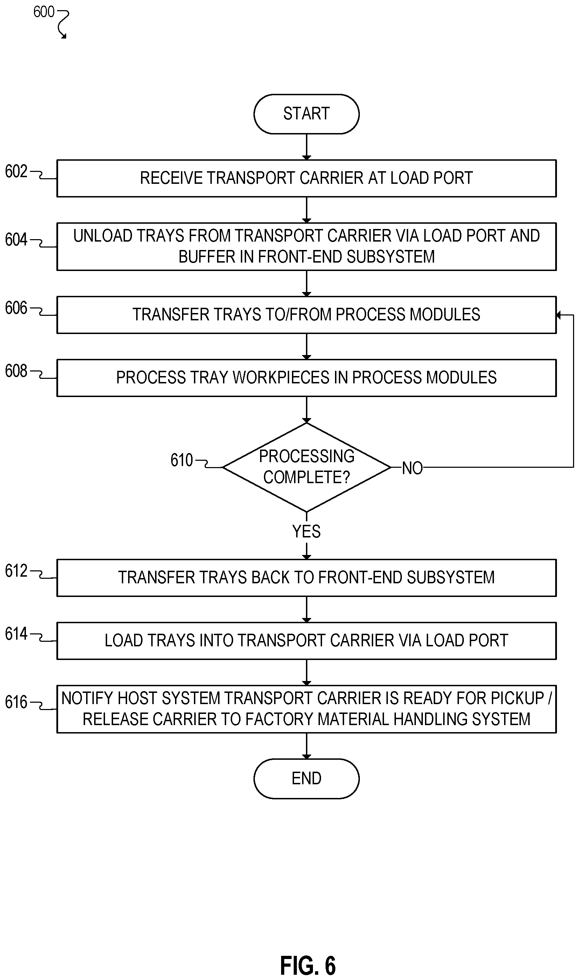

**FIG. 6** illustrates an example process flow 600 performed by a semiconductor manufacturing mainframe system in accordance with certain embodiments. It will be appreciated in light of the present disclosure that the illustrated process flow is only one example of the operation or implementation of a mainframe system according to the embodiments disclosed herein.

In some embodiments, for example, the illustrated process flow may be performed by an equipment mainframe system for manufacturing semiconductor devices, such as mainframe 100 and/or the process modules 124 docked on mainframe 100. For example, the mainframe may include a control subsystem, a front-end subsystem, a process module rack subsystem, a mainframe material handling subsystem (e.g., one or more delivery robots), and a utility distribution subsystem.

The control subsystem may include any suitable type of processing or control circuitry (e.g., central processing units (CPUs), processors, controllers) to control the operation of the mainframe and/or its respective subsystems, communicate with the host system (e.g., factory control system and/or AMHS) and the process modules, and so forth.

The front-end subsystem may include one or more load ports to receive transport carriers containing semiconductor workpieces (e.g., panels, wafers, substrates, integrated circuit dies, integrated circuit packages).

The rack subsystem may include one or more racks to removably couple or dock process modules. For example, each rack may include multiple slots to dock process modules in designated positions on the rack. In some embodiments, the slots may be designed to dock process modules with predefined or standardized sizes/dimensions (e.g., a process module with standard width, double width, or triple width may be docked within one, two, or three slots, respectively). Further, the racks may be designed to arrange the docked process modules in rows (e.g., multiple rows positioned horizontally and/or vertically relative to each other). For example, the slots on each rack may be arranged into one or more rows such that, when process modules are docked on the rack, they are arranged into one or more rows of process modules. In some embodiments, the rack subsystem may enable multiple rows of process modules to be docked on opposite sides of a center transport lane. For example, the rack subsystem may support four rows of process modules total, with two rows of process modules stacked vertically on each side of the center transport lane.

The mainframe material handling subsystem may include one or more delivery robots (e.g., within the center transport lane between the rows of process modules) to transfer semiconductor workpieces to and from the process modules.

The utility distribution subsystem may include a network of utility connections to connect utilities (e.g., power, air, water, chemicals/gas, vacuum, exhaust, network connectivity) to the mainframe and route the utilities to the process modules (e.g., via each rack slot/position).

The process flow begins at block 602, where a transport carrier is received at one of the load ports on the front-end subsystem of the mainframe. For example, the transport carrier may be transported to and placed on the load port by the factory material handling system, such as a factory automated material handling system (AMHS) (e.g., ceiling-mounted conveyor system, ground-based robots) or person-guided vehicle (PGV) (e.g., trolly/cart). In some embodiments, the load port may include one or more docking mechanisms to securely hold the transport carrier in place (e.g., when unloading and/or reloading its contents).

Moreover, the transport carrier may contain one or more semiconductor workpieces, such as panels, wafers, substrates, integrated circuit dies, integrated circuit packages, and so forth. For example, in some embodiments, the transport carrier may be designed to hold one or more trays (or one or more stacks of trays), and each tray may hold one or more semiconductor workpieces.

Further, in some embodiments, the trays may vary in size in order to hold semiconductor workpieces of varying sizes. For example, the transport carrier may be designed to hold trays of multiple predefined sizes (e.g., with standardized dimensions), which are respectively capable of holding semiconductor workpieces of varying sizes (and numbers).

Alternatively, in some embodiments, the transport carrier may be designed to hold semiconductor workpieces directly-without using trays-and the respective mainframe subsystems may similarly be designed to handle the semiconductor workpieces directly.

The process flow then proceeds to block 604 to unload the trays of semiconductor workpieces from the transport carrier via the load port and buffer the trays in the front-end subsystem. For example, the trays in the transport carrier may be unloaded, unstacked (if necessary), and buffered (e.g., temporarily stored) within the front-end subsystem until the mainframe is ready to transfer them to the process modules for processing.

In some embodiments, for example, an automated door on the transport carrier may be opened at the load port, and one or more robots in the front-end subsystem may remove the trays from the transport carrier (via the load port) and place them on a tray buffer (e.g., one or more racks and/or conveyors for holding/moving trays) in the front-end subsystem, which may include mechanisms to unstack the trays (if necessary).

The process flow then proceeds to block 606 to transfer the trays of semiconductor workpieces to and from process modules. For example, the trays may be transferred from the front-end subsystem to the process modules, between the process modules, and eventually from the process modules back to the front-end subsystem (e.g., in the order required by the corresponding semiconductor process flow for each tray).

In some embodiments, for example, the mainframe delivery robots may be configured to move within the center transport lane (e.g., the lane between the rows of process modules docked on the rack subsystem) to transfer individual trays to and from some or all of the process modules in the particular order required by the corresponding semiconductor process flow.

Further, in some embodiments, the delivery robots may be configured to transfer trays to and from process modules directly and/or indirectly via one or more tray handoff buffers. For example, in some embodiments, the delivery robots may transport trays within different zones of the center transport lane, and the mainframe may include one or more tray handoff buffers (e.g., racks to hold trays) positioned between the delivery robots or zones to enable trays to be handed off between the delivery robots. For example, if a tray needs to be transferred between zones, one of the robots may transfer the tray from its current location in the first zone (e.g., the front-end subsystem or one of the process modules) to a tray handoff buffer, and another delivery robot may pick up the tray from the tray handoff buffer and transfer the tray to the appropriate destination in the second zone (e.g., another process module or back to the front-end subsystem).

The process flow then proceeds to block 608 to process the semiconductor workpieces in the trays using the respective process modules. For example, the process modules may vary in function and/or size, and each process module may be designed to perform certain operations (e.g., film deposition, etch, annealing, ion implantation, cleaning, assembly, bonding, singulation, and metrology measurements). Thus, when each tray is transferred to a particular process module at block 606, the process module may perform its designated operation(s) on the semiconductor workpieces in that tray. In this manner, once a particular tray has been transferred to some or all of the process modules in the order required by the corresponding semiconductor process flow, all of the requisite processing for that semiconductor process flow has been performed on the semiconductor workpieces in that tray.

The process flow then proceeds to block 610 to determine whether processing is complete. For example, processing may be complete for a given tray when the semiconductor workpieces in the tray have been processed by all of the process modules required for the particular semiconductor process flow. If processing is not complete for a given tray, the process flow proceeds back to block 606 to transfer the tray to the next process module required by the particular semiconductor process flow. Once processing is complete for a given tray, the process flow proceeds to block 612 to transfer the tray back to the front-end subsystem (e.g., via the delivery robot(s)). The process flow continues in this manner until all of the trays from the transport carrier have been processed and transferred back to the front-end subsystem.

The process flow then proceeds to block 614 to load the trays back into the transport carrier via one of the load ports on the front-end subsystem of the mainframe. In some embodiments, for example, the trays may be restacked by the stack/unstack mechanisms in the tray buffer subsystem (if necessary), the automated door on the transport carrier may be opened at the load port, and the robot(s) in the front-end subsystem may load the trays back into the transport carrier.

The process flow then proceeds to block 616 to notify the host system that the transport carrier is ready for pickup, and the transport carrier is then released to the factory material handling system (e.g., factory AMHS, person-guided vehicle (PGV), etc.). In some embodiments, for example, the mainframe controller may notify the host system that the transport carrier is ready to be picked up from the load port, and the load port may release the transport carrier from its docking mechanisms.

The transport carrier may then be picked up from the load port and transferred to the next destination in the factory (e.g., by the factory AMHS or a PGV), such as another mainframe (e.g., to continue processing the workpieces) or a storage facility (e.g., to store incomplete or completed workpieces, such as in the AMHS stockers).

At this point, the process flow may be complete. In some embodiments, however, the process flow may restart and/or certain blocks may be repeated. For example, in some embodiments, the process flow may restart at block 602 to continue receiving transport carriers and processing the semiconductor workpieces in the transport carriers.

### Example Integrated Circuit Embodiments

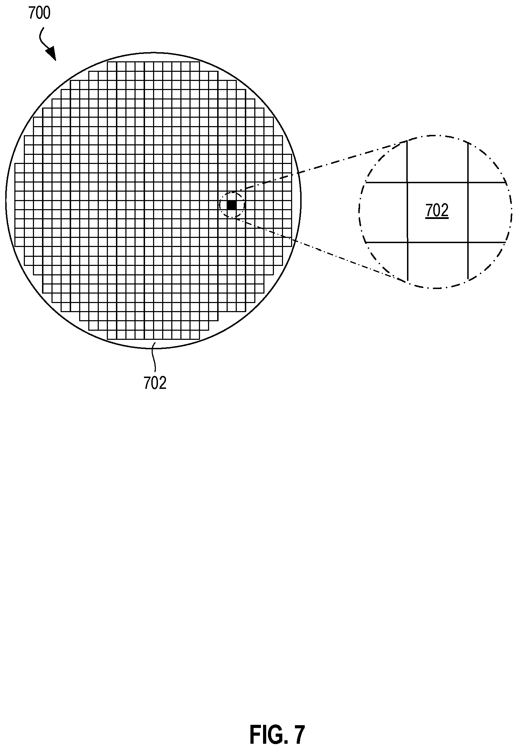

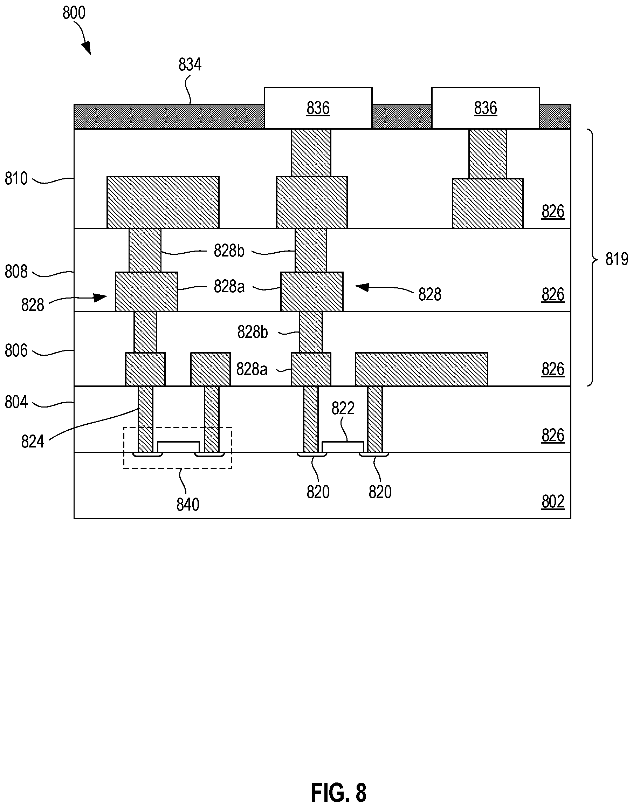

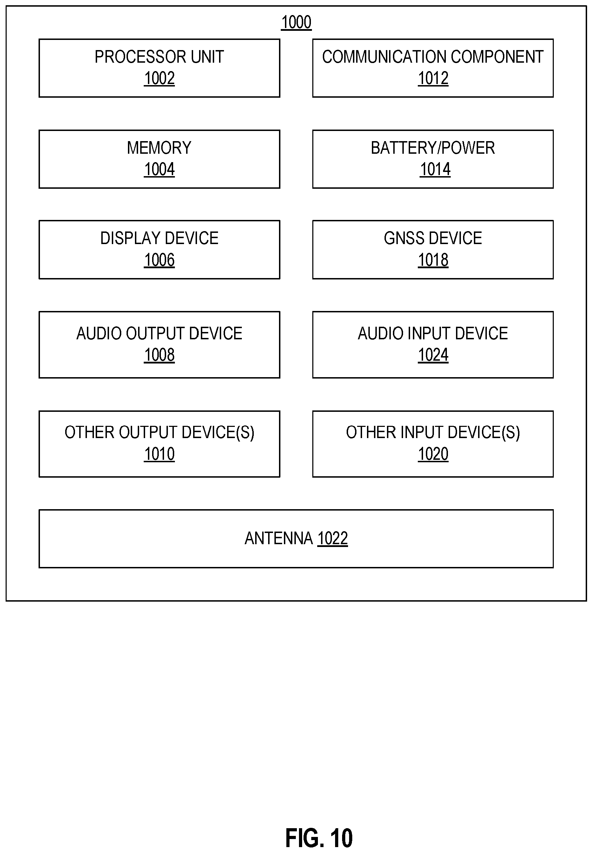

**FIG. 7** is a top view of a wafer 700 and dies 702 that may be included in any of the embodiments disclosed herein. In some embodiments, for example, the wafer 700 and/or dies 702 may be processed, manufactured, and/or assembled using one or more semiconductor equipment mainframes (e.g., mainframe 100) as described throughout this disclosure. The wafer 700 may be composed of semiconductor material and may include one or more dies 702 having integrated circuit structures formed on a surface of the wafer 700. The individual dies 702 may be a repeating unit of an integrated circuit product that includes any suitable integrated circuit. After the fabrication of the semiconductor product is complete, the wafer 700 may undergo a singulation process in which the dies 702 are separated from one another to provide discrete "chips" of the integrated circuit product. The die 702 may be any of the dies disclosed herein. The die 702 may include one or more transistors (e.g., some of the transistors 840 of FIG. 8, discussed below), supporting circuitry to route electrical signals to the transistors, passive components (e.g., signal traces, resistors, capacitors, or inductors), and/or any other integrated circuit components. In some embodiments, the wafer 700 or the die 702 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 702. For example, a memory array formed by multiple memory devices may be formed on a same die 702 as a processor unit (e.g., the processor unit 1002 of FIG. 10) or other logic that is configured to store information in the memory devices or execute instructions stored in the memory array. Various ones of the microelectronic assemblies disclosed herein may be manufactured using a die-to-wafer assembly technique in which some dies are attached to a wafer 700 that include others of the dies, and the wafer 700 is subsequently singulated.

**FIG. 8** is a cross-sectional side view of an integrated circuit device 800 that may be included in any of the embodiments disclosed herein (e.g., in any of the dies). In some embodiments, for example, the integrated circuit device 800 may be processed, manufactured, and/or assembled using one or more semiconductor equipment mainframes (e.g., mainframe 100) as described throughout this disclosure. One or more of the integrated circuit devices 800 may be included in one or more dies 702 (FIG. 7). The integrated circuit device 800 may be formed on a die substrate 802 (e.g., the wafer 700 of FIG. 7) and may be included in a die (e.g., the die 702 of FIG. 7). The die substrate 802 may be a semiconductor substrate composed of semiconductor material systems including, for example, n-type or p-type materials systems (or a combination of both). The die substrate 802 may include, for example, a crystalline substrate formed using a bulk silicon or a silicon-on-insulator (SOI) substructure. In some embodiments, the die substrate 802 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 802. Although a few examples of materials from which the die substrate 802 may be formed are described here, any material that may serve as a foundation for an integrated circuit device 800 may be used. The die substrate 802 may be part of a singulated die (e.g., the dies 702 of FIG. 7) or a wafer (e.g., the wafer 700 of FIG. 7).

The integrated circuit device 800 may include one or more device layers 804 disposed on the die substrate 802. The device layer 804 may include features of one or more transistors 840 (e.g., metal oxide semiconductor field-effect transistors (MOSFETs)) formed on the die substrate 802. The transistors 840 may include, for example, one or more source and/or drain (S/D) regions 820, a gate 822 to control current flow between the S/D regions 820, and one or more S/D contacts 824 to route electrical signals to/from the S/D regions 820. The transistors 840 may include additional features not depicted for the sake of clarity, such as device isolation regions, gate contacts, and the like. The transistors 840 are not limited to the type and configuration depicted in FIG. 8 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

A transistor 840 may include a gate 822 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 840 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 840 along the source-channel-drain direction, the gate electrode may consist of a U-shaped structure that includes a bottom portion substantially parallel to the surface of the die substrate 802 and two sidewall portions that are substantially perpendicular to the top surface of the die substrate 802. In other embodiments, at least one of the metal layers that form the gate electrode may simply be a planar layer that is substantially parallel to the top surface of the die substrate 802 and does not include sidewall portions substantially perpendicular to the top surface of the die substrate 802. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 820 may be formed within the die substrate 802 adjacent to the gate 822 of individual transistors 840. The S/D regions 820 may be formed using an implantation/diffusion process or an etching/deposition process, for example. In the former process, dopants such as boron, aluminum, antimony, phosphorous, or arsenic may be ion-implanted into the die substrate 802 to form the S/D regions 820. An annealing process that activates the dopants and causes them to diffuse farther into the die substrate 802 may follow the ion-implantation process. In the latter process, the die substrate 802 may first be etched to form recesses at the locations of the S/D regions 820. An epitaxial deposition process may then be carried out to fill the recesses with material that is used to fabricate the S/D regions 820. In some implementations, the S/D regions 820 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 820 may be formed using one or more alternate semiconductor materials such as germanium or a group III-V material or alloy. In further embodiments, one or more layers of metal and/or metal alloys may be used to form the S/D regions 820.

Electrical signals, such as power and/or input/output (I/O) signals, may be routed to and/or from the devices (e.g., transistors 840) of the device layer 804 through one or more interconnect layers disposed on the device layer 804 (illustrated in FIG. 8 as interconnect layers 806-810). For example, electrically conductive features of the device layer 804 (e.g., the gate 822 and the S/D contacts 824) may be electrically coupled with the interconnect structures 828 of the interconnect layers 806-810. The one or more interconnect layers 806-810 may form a metallization stack (also referred to as an "ILD stack") 819 of the integrated circuit device 800.

The interconnect structures 828 may be arranged within the interconnect layers 806-810 to route electrical signals according to a wide variety of designs; in particular, the arrangement is not limited to the particular configuration of interconnect structures 828 depicted in FIG. 8. Although a particular number of interconnect layers 806-810 is depicted in FIG. 8, embodiments of the present disclosure include integrated circuit devices having more or fewer interconnect layers than depicted.

In some embodiments, the interconnect structures 828 may include lines 828a and/or vias 828b filled with an electrically conductive material such as a metal. The lines 828a may be arranged to route electrical signals in a direction of a plane that is substantially parallel with a surface of the die substrate 802 upon which the device layer 804 is formed. For example, the lines 828a may route electrical signals in a direction in and out of the page and/or in a direction across the page from the perspective of FIG. 8. The vias 828b may be arranged to route electrical signals in a direction of a plane that is substantially perpendicular to the surface of the die substrate 802 upon which the device layer 804 is formed. In some embodiments, the vias 828b may electrically couple lines 828a of different interconnect layers 806-810 together.

The interconnect layers 806-810 may include a dielectric material 826 disposed between the interconnect structures 828, as shown in FIG. 8. In some embodiments, dielectric material 826 disposed between the interconnect structures 828 in different ones of the interconnect layers 806-810 may have different compositions; in other embodiments, the composition of the dielectric material 826 between different interconnect layers 806-810 may be the same. The device layer 804 may include a dielectric material 826 disposed between the transistors 840 and a bottom layer of the metallization stack as well. The dielectric material 826 included in the device layer 804 may have a different composition than the dielectric material 826 included in the interconnect layers 806-810; in other embodiments, the composition of the dielectric material 826 in the device layer 804 may be the same as a dielectric material 826 included in any one of the interconnect layers 806-810.

A first interconnect layer 806 (referred to as Metal 1 or "M1") may be formed directly on the device layer 804. In some embodiments, the first interconnect layer 806 may include lines 828a and/or vias 828b, as shown. The lines 828a of the first interconnect layer 806 may be coupled with contacts (e.g., the S/D contacts 824) of the device layer 804. The vias 828b of the first interconnect layer 806 may be coupled with the lines 828a of a second interconnect layer 808.

The second interconnect layer 808 (referred to as Metal 2 or "M2") may be formed directly on the first interconnect layer 806. In some embodiments, the second interconnect layer 808 may include via 828b to couple the lines 828 of the second interconnect layer 808 with the lines 828a of a third interconnect layer 810. Although the lines 828a and the vias 828b are structurally delineated with a line within individual interconnect layers for the sake of clarity, the lines 828a and the vias 828b may be structurally and/or materially contiguous (e.g., simultaneously filled during a dual-damascene process) in some embodiments.

The third interconnect layer 810 (referred to as Metal 3 or "M3") (and additional interconnect layers, as desired) may be formed in succession on the second interconnect layer 808 according to similar techniques and configurations described in connection with the second interconnect layer 808 or the first interconnect layer 806. In some embodiments, the interconnect layers that are "higher up" in the metallization stack 819 in the integrated circuit device 800 (i.e., farther away from the device layer 804) may be thicker that the interconnect layers that are lower in the metallization stack 819, with lines 828a and vias 828b in the higher interconnect layers being thicker than those in the lower interconnect layers.

The integrated circuit device 800 may include a solder resist material 834 (e.g., polyimide or similar material) and one or more conductive contacts 836 formed on the interconnect layers 806-810. In FIG. 8, the conductive contacts 836 are illustrated as taking the form of bond pads. The conductive contacts 836 may be electrically coupled with the interconnect structures 828 and configured to route the electrical signals of the transistor(s) 840 to external devices. For example, solder bonds may be formed on the one or more conductive contacts 836 to mechanically and/or electrically couple an integrated circuit die including the integrated circuit device 800 with another component (e.g., a printed circuit board). The integrated circuit device 800 may include additional or alternate structures to route the electrical signals from the interconnect layers 806-810; for example, the conductive contacts 836 may include other analogous features (e.g., posts) that route the electrical signals to external components. The conductive contacts 836 may serve as any of the conductive contacts described throughout this disclosure.

In some embodiments in which the integrated circuit device 800 is a double-sided die, the integrated circuit device 800 may include another metallization stack (not shown) on the opposite side of the device layer(s) 804. This metallization stack may include multiple interconnect layers as discussed above with reference to the interconnect layers 806-810, to provide conductive pathways (e.g., including conductive lines and vias) between the device layer(s) 804 and additional conductive contacts (not shown) on the opposite side of the integrated circuit device 800 from the conductive contacts 836. These additional conductive contacts may serve as any of the conductive contacts described throughout this disclosure.

In other embodiments in which the integrated circuit device 800 is a double-sided die, the integrated circuit device 800 may include one or more through silicon vias (TSVs) through the die substrate 802; these TSVs may make contact with the device layer(s) 804, and may provide conductive pathways between the device layer(s) 804 and additional conductive contacts (not shown) on the opposite side of the integrated circuit device 800 from the conductive contacts 836. These additional conductive contacts may serve as any of the conductive contacts described throughout this disclosure. In some embodiments, TSVs extending through the substrate can be used for routing power and ground signals from conductive contacts on the opposite side of the integrated circuit device 800 from the conductive contacts 836 to the transistors 840 and any other components integrated into the die 800, and the metallization stack 819 can be used to route I/O signals from the conductive contacts 836 to transistors 840 and any other components integrated into the die 800.

Multiple integrated circuit devices 800 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

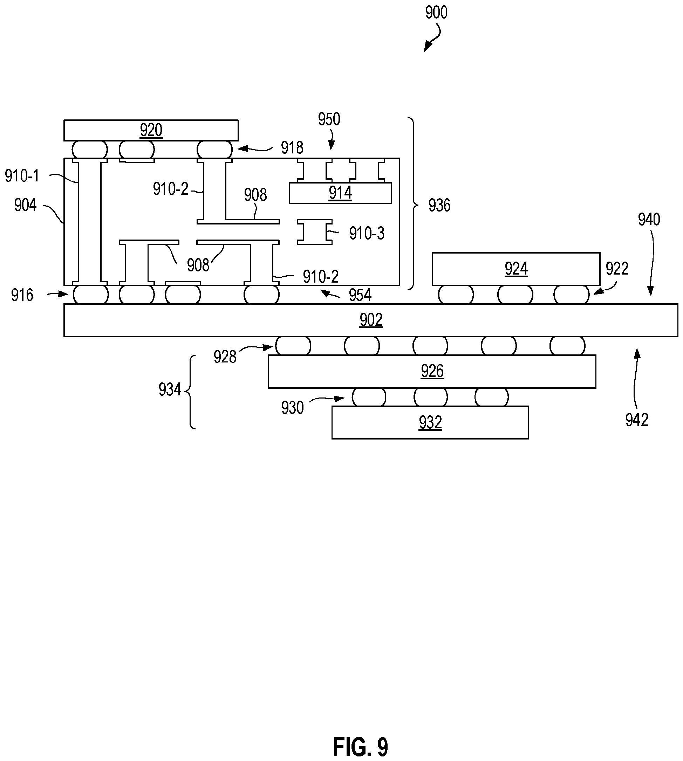

**FIG. 9** is a cross-sectional side view of an integrated circuit device assembly 900 that may include any of the embodiments disclosed herein. In some embodiments, for example, the integrated circuit device assembly 900 may be processed, manufactured, and/or assembled using one or more semiconductor equipment mainframes (e.g., mainframe 100) as described throughout this disclosure. In some embodiments, the integrated circuit device assembly 900 may be a microelectronic assembly. The integrated circuit device assembly 900 includes a number of components disposed on a circuit board 902 (which may be a motherboard, system board, mainboard, etc.). The integrated circuit device assembly 900 includes components disposed on a first face 940 of the circuit board 902 and an opposing second face 942 of the circuit board 902; generally, components may be disposed on one or both faces 940 and 942. Any of the integrated circuit components discussed below with reference to the integrated circuit device assembly 900 may take the form of any suitable ones of the embodiments of the microelectronic assemblies disclosed herein.

In some embodiments, the circuit board 902 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 902. In other embodiments, the circuit board 902 may be a non-PCB substrate. The integrated circuit device assembly 900 illustrated in FIG. 9 includes a package-on-interposer structure 936 coupled to the first face 940 of the circuit board 902 by coupling components 916. The coupling components 916 may electrically and mechanically couple the package-on-interposer structure 936 to the circuit board 902, and may include solder balls (as shown in FIG. 9), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 916 may serve as the coupling components illustrated or described for any of the substrate assembly or substrate assembly components described herein, as appropriate.

The package-on-interposer structure 936 may include an integrated circuit component 920 coupled to an interposer 904 by coupling components 918. The coupling components 918 may take any suitable form for the application, such as the forms discussed above with reference to the coupling components 916. Although a single integrated circuit component 920 is shown in FIG. 9, multiple integrated circuit components may be coupled to the interposer 904; indeed, additional interposers may be coupled to the interposer 904. The interposer 904 may provide an intervening substrate used to bridge the circuit board 902 and the integrated circuit component 920.

The integrated circuit component 920 may be a packaged or unpackaged integrated circuit product that includes one or more integrated circuit dies (e.g., the die 702 of FIG. 7, the integrated circuit device 800 of FIG. 8) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 920, a single monolithic integrated circuit die comprises solder bumps attached to contacts on the die. The solder bumps allow the die to be directly attached to the interposer 904. The integrated circuit component 920 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 920 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 920 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 920 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 904 may spread connections to a wider pitch or reroute a connection to a different connection. For example, the interposer 904 may couple the integrated circuit component 920 to a set of ball grid array (BGA) conductive contacts of the coupling components 916 for coupling to the circuit board 902. In the embodiment illustrated in FIG. 9, the integrated circuit component 920 and the circuit board 902 are attached to opposing sides of the interposer 904; in other embodiments, the integrated circuit component 920 and the circuit board 902 may be attached to a same side of the interposer 904. In some embodiments, three or more components may be interconnected by way of the interposer 904.

In some embodiments, the interposer 904 may be formed as a PCB, including multiple metal layers separated from one another by layers of dielectric material and interconnected by electrically conductive vias. In some embodiments, the interposer 904 may be formed of an epoxy resin, a fiberglass-reinforced epoxy resin, an epoxy resin with inorganic fillers, a ceramic material, or a polymer material such as polyimide. In some embodiments, the interposer 904 may be formed of alternate rigid or flexible materials that may include the same materials described above for use in a semiconductor substrate, such as silicon, germanium, and other group III-V and group IV materials. The interposer 904 may include metal interconnects 908 and vias 910, including but not limited to through hole vias 910-1 (that extend from a first face 950 of the interposer 904 to a second face 954 of the interposer 904), blind vias 910-2 (that extend from the first or second faces 950 or 954 of the interposer 904 to an internal metal layer), and buried vias 910-3 (that connect internal metal layers).

In some embodiments, the interposer 904 can comprise a silicon interposer. Through silicon vias (TSV) extending through the silicon interposer can connect connections on a first face of a silicon interposer to an opposing second face of the silicon interposer. In some embodiments, an interposer 904 comprising a silicon interposer can further comprise one or more routing layers to route connections on a first face of the interposer 904 to an opposing second face of the interposer 904.

The interposer 904 may further include embedded devices 914, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 904. The package-on-interposer structure 936 may take the form of any of the package-on-interposer structures known in the art. In embodiments where the interposer is a non-printed circuit board

The integrated circuit device assembly 900 may include an integrated circuit component 924 coupled to the first face 940 of the circuit board 902 by coupling components 922. The coupling components 922 may take the form of any of the embodiments discussed above with reference to the coupling components 916, and the integrated circuit component 924 may take the form of any of the embodiments discussed above with reference to the integrated circuit component 920.

The integrated circuit device assembly 900 illustrated in FIG. 9 includes a package-on-package structure 934 coupled to the second face 942 of the circuit board 902 by coupling components 928. The package-on-package structure 934 may include an integrated circuit component 926 and an integrated circuit component 932 coupled together by coupling components 930 such that the integrated circuit component 926 is disposed between the circuit board 902 and the integrated circuit component 932. The coupling components 928 and 930 may take the form of any of the embodiments of the coupling components 916 discussed above, and the integrated circuit components 926 and 932 may take the form of any of the embodiments of the integrated circuit component 920 discussed above. The package-on-package structure 934 may be configured in accordance with any of the package-on-package structures known in the art.

**FIG. 10** is a block diagram of an example electrical device 1000 that may include one or more of the embodiments disclosed herein. For example, any of the components of the electrical device 1000 may include one or more of the integrated circuit device assemblies 900, integrated circuit components 920, integrated circuit devices 800, or integrated circuit dies 702 disclosed herein. Moreover, in some embodiments, any of the components of the electrical device 1000 may be processed, manufactured, and/or assembled using one or more semiconductor equipment mainframes (e.g., mainframe 100) as described throughout this disclosure. Alternatively, and/or additionally, some or all of the components of the electrical device 1000 may be used as a control system for a semiconductor equipment mainframe, process module, and/or factory. A number of components are illustrated in FIG. 10 as included in the electrical device 1000, but any one or more of these components may be omitted or duplicated, as suitable for the application. In some embodiments, some or all of the components included in the electrical device 1000 may be attached to one or more motherboards mainboards, or system boards. In some embodiments, one or more of these components are fabricated onto a single system-on-a-chip (SoC) die.

Additionally, in various embodiments, the electrical device 1000 may not include one or more of the components illustrated in FIG. 10, but the electrical device 1000 may include interface circuitry for coupling to the one or more components. For example, the electrical device 1000 may not include a display device 1006, but may include display device interface circuitry (e.g., a connector and driver circuitry) to which a display device 1006 may be coupled. In another set of examples, the electrical device 1000 may not include an audio input device 1024 or an audio output device 1008, but may include audio input or output device interface circuitry (e.g., connectors and supporting circuitry) to which an audio input device 1024 or audio output device 1008 may be coupled.

The electrical device 1000 may include one or more processor units 1002 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 1002 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 1000 may include a memory 1004, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 1004 may include memory that is located on the same integrated circuit die as the processor unit 1002. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 1000 can comprise one or more processor units 1002 that are heterogeneous or asymmetric to another processor unit 1002 in the electrical device 1000. There can be a variety of differences between the processing units 1002 in a system in terms of a spectrum of metrics of merit including architectural, microarchitectural, thermal, power consumption characteristics, and the like. These differences can effectively manifest themselves as asymmetry and heterogeneity among the processor units 1002 in the electrical device 1000.

In some embodiments, the electrical device 1000 may include a communication component 1012 (e.g., one or more communication components). For example, the communication component 1012 can manage wireless communications for the transfer of data to and from the electrical device 1000. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 1012 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 1012 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 1012 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 1012 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 1012 may operate in accordance with other wireless protocols in other embodiments. The electrical device 1000 may include an antenna 1022 to facilitate wireless communications and/or to receive other wireless communications (such as AM or FM radio transmissions).

In some embodiments, the communication component 1012 may manage wired communications, such as electrical, optical, or any other suitable communication protocols (e.g., IEEE 802.3 Ethernet standards). As noted above, the communication component 1012 may include multiple communication components. For instance, a first communication component 1012 may be dedicated to shorter-range wireless communications such as Wi-Fi or Bluetooth, and a second communication component 1012 may be dedicated to longer-range wireless communications such as global positioning system (GPS), EDGE, GPRS, CDMA, WiMAX, LTE, EV-DO, or others. In some embodiments, a first communication component 1012 may be dedicated to wireless communications, and a second communication component 1012 may be dedicated to wired communications.

The electrical device 1000 may include battery/power circuitry 1014. The battery/power circuitry 1014 may include one or more energy storage devices (e.g., batteries or capacitors) and/or circuitry for coupling components of the electrical device 1000 to an energy source separate from the electrical device 1000 (e.g., AC line power).

The electrical device 1000 may include a display device 1006 (or corresponding interface circuitry, as discussed above). The display device 1006 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 1000 may include an audio output device 1008 (or corresponding interface circuitry, as discussed above). The audio output device 1008 may include any embedded or wired or wirelessly connected external device that generates an audible indicator, such speakers, headsets, or earbuds.

The electrical device 1000 may include an audio input device 1024 (or corresponding interface circuitry, as discussed above). The audio input device 1024 may include any embedded or wired or wirelessly connected device that generates a signal representative of a sound, such as microphones, microphone arrays, or digital instruments (e.g., instruments having a musical instrument digital interface (MIDI) output). The electrical device 1000 may include a Global Navigation Satellite System (GNSS) device 1018 (or corresponding interface circuitry, as discussed above), such as a Global Positioning System (GPS) device. The GNSS device 1018 may be in communication with a satellite-based system and may determine a geolocation of the electrical device 1000 based on information received from one or more GNSS satellites, as known in the art.

The electrical device 1000 may include other output device(s) 1010 (or corresponding interface circuitry, as discussed above). Examples of the other output device(s) 1010 may include an audio codec, a video codec, a printer, a wired or wireless transmitter for providing information to other devices, or an additional storage device.

The electrical device 1000 may include other input device(s) 1020 (or corresponding interface circuitry, as discussed above). Examples of the other input device(s) 1020 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 1000 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 1000 may be any other electronic device that processes data. In some embodiments, the electrical device 1000 may comprise multiple discrete physical components. Given the range of devices that the electrical device 1000 can be manifested as in various embodiments, in some embodiments, the electrical device 1000 can be referred to as a computing device or a computing system.

### Examples

Illustrative examples of the technologies described throughout this disclosure are provided below. Embodiments of these technologies may include any one or more, and any combination of, the examples described below. In some embodiments, at least one of the systems or components set forth in one or more of the preceding figures may be configured to perform one or more operations, techniques, processes, and/or methods as set forth in the following examples.

Example 1 includes a mainframe for semiconductor device manufacturing, comprising: one or more racks to removably couple a plurality of process modules, wherein the process modules are to be arranged in a plurality of rows on the one or more racks, and wherein the process modules are to perform operations on semiconductor workpieces; and one or more robots to transfer the semiconductor workpieces to and from the process modules, wherein the one or more robots are in a lane between the rows.

Example 2 includes the mainframe of Example 1, further comprising one or more load ports to receive transport carriers, wherein the transport carriers are to contain the semiconductor workpieces.

Example 3 includes the mainframe of any of Examples 1-2, further comprising: a first set of utility connections to connect to a plurality of utilities; and a second set of utility connections to route the utilities to the process modules.

Example 4 includes the mainframe of Example 3, wherein the utilities include one or more of power, air, water, exhaust, or network connectivity.

Example 5 includes the mainframe of any of Examples 1-4, wherein the one or more racks comprise a plurality of slots to removably couple the process modules in a plurality of positions on the one or more racks.

Example 6 includes the mainframe of any of Examples 1-5, wherein the process modules vary in size and function.

Example 7 includes the mainframe of any of Examples 1-6, wherein the rows include a first set of rows and a second set of rows, wherein the first set of rows is arranged vertically, the second set of rows is arranged vertically, and the lane is between the first set of rows and the second set of rows.

Example 8 includes the mainframe of any of Examples 1-7, wherein the one or more robots are further to move within the lane to transfer the semiconductor workpieces between the process modules in any order.

Example 9 includes the mainframe of any of Examples 1-8, wherein the semiconductor workpieces include one or more panels, wafers, substrates, integrated circuit dies, or integrated circuit packages.

Example 10 includes a system, comprising: one or more load ports to receive transport carriers, wherein the transport carriers are to contain semiconductor workpieces; one or more racks to dock a plurality of process modules, wherein the process modules are to be arranged in a plurality of rows on the one or more racks, and wherein the process modules are to perform operations on the semiconductor workpieces; one or more robots to transfer the semiconductor workpieces to and from the process modules, wherein the one or more robots are in a lane between the rows; and a plurality of utility connections to connect to a plurality of utilities and route the utilities to the process modules.

Example 11 includes the system of Example 10, wherein: the transport carriers are further to contain trays, wherein the trays are to contain the semiconductor workpieces; and the one or more robots are to transfer the trays to and from the process modules.

Example 12 includes the system of Example 11, wherein: the one or more robots comprise a plurality of robots; and the system further comprises one or more second racks to handoff one or more of the trays between the robots.

Example 13 includes the system of Example 11, further comprising a front-end subsystem, wherein the front-end subsystem comprises: the one or more load ports; one or more second racks; and one or more second robots to unload the trays from the transport carriers onto the one or more second racks.

Example 14 includes the system of any of Examples 11-13, wherein the trays have a plurality of predefined sizes.

Example 15 includes the system of any of Examples 10-14, wherein: the process modules have a plurality of predefined sizes; and the one or more racks comprise a plurality of slots to removably couple the process modules having the predefined sizes.

Example 16 includes the system of any of Examples 10-15, wherein the rows of the process modules are arranged horizontally and vertically on the one or more racks.

Example 17 includes the system of any of Examples 10-16, further comprising the plurality of process modules.

Example 18 includes a method, comprising: receiving a transport carrier at a load port; unloading a tray from the transport carrier via the load port, wherein the tray contains one or more semiconductor workpieces; and transferring the tray to and from at least some of a plurality of process modules, wherein the process modules are arranged in a plurality of rows on one or more racks.

Example 19 includes the method of Example 18, wherein transferring the tray to and from at least some of the process modules comprises: transferring, by one or more robots, the tray to and from at least some of the process modules, wherein the one or more robots are in a lane between the rows of the process modules.

Example 20 includes the method of any of Examples 18-19, further comprising performing, by at least some of the process modules, one or more operations on the one or more semiconductor workpieces.

While the concepts of the present disclosure are susceptible to various modifications and alternative forms, specific embodiments thereof have been shown by way of example in the drawings and are described herein in detail. It should be understood, however, that there is no intent to limit the concepts of the present disclosure to the particular forms disclosed, but on the contrary, the intention is to cover all modifications, equivalents, and alternatives consistent with the present disclosure and the appended claims.

In the drawings, some structural or method features may be shown in specific arrangements and/or orderings. However, it should be appreciated that such specific arrangements and/or orderings may not be required. Rather, in some embodiments, such features may be arranged in a different manner and/or order than shown in the illustrative figures. Additionally, the inclusion of a structural or method feature in a particular figure is not meant to imply that such feature is required in all embodiments and, in some embodiments, may not be included or may be combined with other features. Further, it should be understood that the various embodiments shown in the figures are illustrative representations and are not necessarily drawn to scale.

Moreover, the illustrations and/or descriptions of various embodiments may be simplified or approximated for ease of understanding, and as a result, they may not necessarily reflect the level of precision nor variation that may be present in actual embodiments. For example, while some figures generally indicate straight lines, right angles, and smooth surfaces, actual implementations of the disclosed embodiments may have less than perfect straight lines and right angles, and some features may have surface topography or otherwise be non-smooth, given real-world limitations of fabrication processes. Similarly, illustrations and/or descriptions of how components are arranged may be simplified or approximated for ease of understanding and may vary by some margin of error in actual embodiments (e.g., due to fabrication processes, etc.).

Unless otherwise specified, the use of the ordinal adjectives "first," "second," and "third," etc., to describe a common object, merely indicate that different instances of like objects to which are being referred and are not intended to imply that the objects so described must be in a given sequence, either temporally, spatially, in ranking or in any other manner.

The terms "substantially," "close," "approximately," "near," and "about," generally refer to being within +/- 10% of a target value (unless otherwise specified). Similarly, terms describing spatial relationships, such as "perpendicular," "orthogonal," or "coplanar," may refer to being substantially within the described spatial relationships (e.g., within +/- 10 degrees of orthogonality).

Certain terminology may also be used in the foregoing description for the purpose of reference only, and thus are not intended to be limiting. For example, terms such as "upper," "lower," "above," "below," "bottom," and "top" refer to directions in the drawings to which reference is made. Terms such as "front," "back," "rear," and "side" describe the orientation and/or location of portions of the component within a consistent but arbitrary frame of reference which is made clear by reference to the text and the associated drawings describing the component under discussion. Such terminology may include the words specifically mentioned above, derivatives thereof, and words of similar import.

The terms "over", "under", "between", "adjacent", "to", and "on" as used herein may refer to a relative position of one layer or component with respect to other layers or components. For example, one layer "over", "under", or "on" another layer, "adjacent" to another layer, or bonded "to" another layer may be directly in contact with the other layer or may have one or more intervening layers. One layer "between" layers may be directly in contact with the layers or may have one or more intervening layers.

The meaning of "a," "an," and "the" include plural references. The meaning of "in" includes "in" and "on."

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

Views labeled "cross-sectional", "profile" and "plan" correspond to orthogonal planes within a cartesian coordinate system. Thus, cross-sectional and profile views are taken in the x-z plane, and plan views are taken in the x-y plane. Typically, profile views in the x-z plane are cross-sectional views. Where appropriate, drawings are labeled with axes to indicate the orientation of the figure.

The term "package" generally refers to a self-contained carrier of one or more dice, where the dice are attached to or embedded in the package substrate, and may be encapsulated for protection, with integrated or wire-bonded interconnects between the dice, along with leads, pins, or bumps located on the external portions of the package substrate. The package may contain a single die, or multiple dice, providing respective functions. The package may be mounted on a printed circuit board for interconnection with other packaged integrated circuits and discrete components, forming a larger circuit.

The terms "dielectric" and "dielectric material" generally refer to any type or number of non-electrically conductive materials. In some cases, dielectric material may be used to make up the structure of a package substrate. For example, dielectric material may be incorporated into an integrated circuit package as layers of laminate film or as a resin molded over integrated circuit dice mounted on the substrate.

The term "metallization" generally refers to metal layers formed on, over, and/or through the dielectric material of the package substrate. The metal layers are generally patterned to form metal structures such as traces and bond pads. The metallization of a package substrate may be confined to a single layer or in multiple layers separated by layers of dielectric.

The term "bond pad" generally refers to metallization structures that terminate integrated traces and vias in integrated circuit packages and dies. The term "solder pad" may be occasionally substituted for "bond pad" and may carry the same or similar meaning.

The term "bump" generally refers to a conductive layer or structure formed on a bond pad, which is typically made of solder or metal and has a round or curved shape, hence the term "bump".

The term "substrate" generally refers to a planar platform comprising dielectric and/or metallization structures. A substrate may mechanically support and electrically couple one or more IC dies on a single platform, with encapsulation of the one or more IC dies by a moldable dielectric material. A substrate may include bumps or pads as bonding interconnects on one or both sides. For example, one side of the substrate, generally referred to as the "die side", may include bumps or pads for chip or die bonding. The opposite side of the substrate, generally referred to as the "land side", may include bumps or pads for bonding the package to a printed circuit board.

The term "assembly" generally refers to a grouping of parts into a single functional unit. For example, certain parts may be permanently bonded together, integrated together, and/or mechanically assembled (e.g., where parts may be removable) into a functional unit.

The terms "coupled" or "connected" means a direct or indirect connection, such as a direct electrical, mechanical, magnetic, or fluidic connection between the things that are connected or an indirect connection, through one or more passive or active intermediary devices.

The term "circuit" or "module" may refer to one or more passive and/or active components that are arranged to cooperate with one another to provide a desired function. The term "signal" may refer to at least one current signal, voltage signal, magnetic signal, or data/clock signal.

Embodiments disclosed herein may be used to manufacture a wide variety of different types of integrated circuits and/or microelectronic devices. Examples of such integrated circuits include, but are not limited to, processors, chipset components, graphics processors, digital signal processors, micro-controllers, and the like. In other embodiments, semiconductor memory may be manufactured. Moreover, the integrated circuits or other microelectronic devices may be used in a wide variety of electronic devices known in the art. For example, in computer systems (e.g., desktop, laptop, server), cellular phones, personal electronics, etc. The integrated circuits may be coupled with a bus and other components in the systems. For example, a processor may be coupled by one or more buses to a memory, a chipset, etc. Each of the processor, the memory, and the chipset, may potentially be manufactured and/or packaged using the approaches disclosed herein.

## Claims

1. A mainframe for semiconductor device manufacturing, comprising:
one or more racks to removably couple a plurality of process modules, wherein the process modules are to be arranged in a plurality of rows on the one or more racks, and wherein the process modules are to perform operations on semiconductor workpieces; and
one or more robots to transfer the semiconductor workpieces to and from the process modules, wherein the one or more robots are in a lane between the rows.

2. The mainframe of Claim 1, further comprising one or more load ports to receive transport carriers, wherein the transport carriers are to contain the semiconductor workpieces.

3. The mainframe of any of Claims 1-2, further comprising:
a first set of utility connections to connect to a plurality of utilities; and
a second set of utility connections to route the utilities to the process modules.

4. The mainframe of Claim 3, wherein the utilities include one or more of power, air, water, exhaust, or network connectivity.

5. The mainframe of any of Claims 1-4, wherein the one or more racks comprise a plurality of slots to removably couple the process modules in a plurality of positions on the one or more racks.

6. The mainframe of any of Claims 1-5, wherein the process modules vary in size and function.

7. The mainframe of any of Claims 1-6, wherein the rows include a first set of rows and a second set of rows, wherein the first set of rows is arranged vertically, the second set of rows is arranged vertically, and the lane is between the first set of rows and the second set of rows.

8. The mainframe of any of Claims 1-7, wherein the one or more robots are further to move within the lane to transfer the semiconductor workpieces between the process modules in any order.

9. The mainframe of any of Claims 1-8, wherein the semiconductor workpieces include one or more panels, wafers, substrates, integrated circuit dies, or integrated circuit packages.

10. The mainframe of any of Claims 2-9, wherein:
the transport carriers are further to contain trays, wherein the trays are to contain the semiconductor workpieces; and
the one or more robots are to transfer the trays to and from the process modules.

11. The mainframe of any of Claims 1-10, wherein the rows of the process modules are arranged horizontally and vertically on the one or more racks.

12. A method, comprising:
receiving a transport carrier at a load port;
unloading a tray from the transport carrier via the load port, wherein the tray contains one or more semiconductor workpieces; and
transferring the tray to and from at least some of a plurality of process modules, wherein the process modules are arranged in a plurality of rows on one or more racks.

13. The method of Claim 12, wherein transferring the tray to and from at least some of the process modules comprises:
transferring, by one or more robots, the tray to and from at least some of the process modules, wherein the one or more robots are in a lane between the rows of the process modules.

14. The method of any of Claims 12-13, further comprising performing, by at least some of the process modules, one or more operations on the one or more semiconductor workpieces.

15. The method of any of Claims 12-14, further comprising loading the tray into the transport carrier via the load port, wherein the transport carrier is to be picked up from the load port.
